Europäisches Patentamt

European Patent Office

Office européen des brevets

(11) Veröffentlichungsnummer: **0 021 084**
**B1**

# EUROPÄISCHE PATENTSCHRIFT

(45) Veröffentlichungstag der Patentschrift:
25.05.83

(51) Int. Cl.³: **G 11 C 19/00**, G 11 C 19/28,
G 06 F 5/00

(21) Anmeldenummer: **80102971.1**

(22) Anmeldetag: **28.05.80**

(54) Monolithisch integrierter Halbleiterspeicher.

(30) Priorität: **18.06.79 DE 2924526**

(43) Veröffentlichungstag der Anmeldung:
**07.01.81 Patentblatt 81/1**

(45) Bekanntmachung des Hinweises auf die Patenterteilung:
**25.05.83 Patentblatt 83/21**

(84) Benannte Vertragsstaaten:
**FR GB IT**

(56) Entgegenhaltungen:
FR-A-1 180 580
FR-A-2 278 114
GB-A-1 370 120
US-A-3 406 346
US-A-3 431 433
US-A-3 745 371
US-A-3 760 368
US-A-3 763 480
US-A-3 772 658
US-A-3 778 773

(73) Patentinhaber: **SIEMENS AKTIENGESELLSCHAFT,
Berlin und München Wittelsbacherplatz 2,
D-8000 München 2 (DE)**

(72) Erfinder: **Rösler, Helmut, Ottobrunnerstrasse 10,
D-8000 München 83 (DE)**

**IEEE JOURNAL OF SOLID-STATE CIRCUITS,
Band SC-11, Nr. 1, Februar 1976, New York, US,
MOHSEN et al.: »A 64-Kbit block addressed
charge-coupled memory«, Seiten 49—58
THE RADIO AND ELECTRONIC ENGINEER, Band
42, Nr. 8, August 1972, London, GB, DEAN: »The
organization of some solid-state stores«, Seiten
357—363
PROCEEDINGS OF THE INTERNATIONAL SYM-
POSIUM ON THE THEORY OF SWITCHING, April
1957, Teil II, Cambridge, US, WAY DONG WOO:
»Magnetic-core logical circuits«, Seiten 173—177
IBM TECHNICAL DISCLOSURE BULLETIN, Band
13, Nr. 5, Oktober 1970, New York, US, W. F.
BEAUSOLEIL: »Shift register storage«, Seiten
1336—1337**

## Monolithisch integrierter Halbleiterspeicher

Die Erfindung betrifft eine integrierte Schaltung mit einer Matrix aus einander gleichen Schieberegisterzellen, bei der einerseits die zu den einzelnen Matrixzeilen gehörenden Schieberegisterzellen zu je einem zeilenparallel arbeitenden Schieberegister und andererseits die zu den einzelnen Matrixspalten gehörenden Schieberegisterzellen zu je einem spaltenparallel arbeitenden Schieberegister zusammenfaßbar sind und der jeweilige dieser beiden Betriebszustände durch je ein Signal ausgelöst wird.

Integrierte Schaltungen dieser Art sind z. B. aus der US-PS 3 760 368 bekannt. Mittels einer Speichermatrix, bei der die einzelnen Speicherelemente durch je eine getaktete Schieberegisterzelle realisiert sind, ist eine mehrfache Richtungsverschiebung von Daten innerhalb der Speichermatrix möglich, ohne daß hierzu die Information in ein äußeres Speicherregister ausgelesen werden muß. Sie ermöglicht auch die gleichzeitige Übertragung einer Anzahl von Datenworten von einer Speicherstelle nach einer anderen Speicherstelle, ohne daß hierzu ein Löschen oder eine Rückstellung von Speicherstellen erforderlich ist.

Es ist nun die Aufgabe der Erfindung, eine solche Speichermatrix weiter auszugestalten, um deren Anwendungsmöglichkeiten weiter zu ermöglichen. Insbesondere soll dabei eine selektive Auswahl von eingespeicherten Datenworten möglich werden, während andererseits auch eine Möglichkeit für den Erhalt der zur Verfügung gestellten Gesamtinformation von Bedeutung sein kann.

Erfindungsgemäß ist zur Lösung der genannten Aufgaben eine entsprechend der eingangs gegebenen Definition ausgestaltete integrierte Schaltung derart beschaffen, daß den einzelnen Schieberegisterzellen der ersten Zeile der Matrix je eine weitere Schieberegisterzelle zugeordnet ist, indem je ein zu einem solchen Paar von Schieberegisterzellen gehörender digitaler Dateneingang einerseits durch ein auf alle diese weiteren Schieberegisterzellen wirkendes erstes Schaltsignal an den Informationseingang der zum jeweiligen Paar gehörigen weiteren Schieberegisterzelle und andererseits durch ein auf alle Schieberegisterzellen der ersten Zeile der Matrix gemeinsam wirkendes zweites Schaltsignal an den Informationseingang der zum jeweiligen Paar gehörigen Schieberegisterzelle der ersten Matrixzeile anschaltbar ist, daß außerdem die Gesamtheit dieser weiteren Schieberegisterzellen zu einem weiteren Schieberegister mit einem Signalausgang zusammengefaßt und zur Informationsverschiebung innerhalb dieses weiteren Schieberegisters eine erste Taktfolge verwendet ist, daß weiterhin für die Informationsverschiebung innerhalb der durch die Schieberegisterzellen in den einzelnen Zeilen der Matrix gebildeten Schieberegister eine für alle diese Schieberegister gemeinsame zweite Taktfolge und für die Informationsverschiebung innerhalb der durch die Schieberegisterzellen in den einzelnen Spalten der Matrix gebildeten Schieberegister eine gemeinsame dritte Taktfolge verwendet ist, daß ferner die Ausgänge der zeilenparallel arbeitenden Schieberegister der Matrix je einen weiteren Signalausgang der Schaltung bilden, und daß schließlich sowohl die genannten Taktfolgen, als auch die gemeinsamen Umschaltsignale in einer von einem gemeinsamen Taktgeber gesteuerten Anlage derart erzeugt sind, daß ein gleichzeitiges Auftreten zweier verschiedener dieser Signale ausgeschlossen ist.

Die Erfindung wird nun anhand der Figuren 1 bis 3 näher vorgestellt. Dabei ist in Figur 1 das Blockschaltbild einer der Erfindung entsprechenden Anlage, in Figur 2 die vorzugsweise anzuwendende Ausgestaltung unter Verwendung sog. quasistatischer Schieberegisterzellen und in Figur 3 ein Beispiel für die Ableitung der zur Steuerung der Anlage erforderlichen Hilfssignale gezeigt.

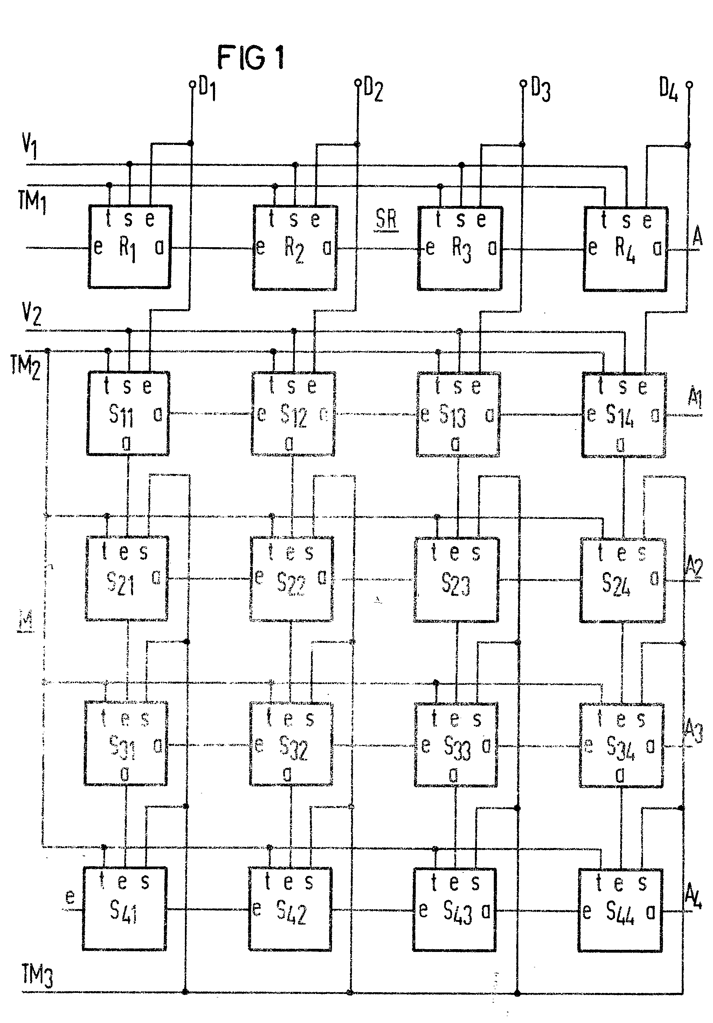

Gemäß dem in Figur 1 dargestellten Blockschaltbild für die erfindungsgemäße Anlage ist eine Matrix M aus vier Zeilen und vier Spalten vorgesehen. Sie besteht demnach aus acht Schieberegisterzellen $S_{11}, \ldots S_{14}, S_{21}, \ldots S_{24}, S_{31}, \ldots S_{34}$ und $S_{41}, \ldots S_{44}$. Allgemein werden für die folgenden Ausführungen die einzelnen Schieberegisterzellen der Matrix M mit »$S_{ik}$« bezeichnet, wobei der Index »i« die Nummer der betreffenden Zeile und der Index »k« die Nummer der betreffenden Spalte der Matrix M bedeutet, in welcher die jeweilige Zelle angeordnet ist. Jede der Schieberegisterzellen $S_{ik}$ hat einen Takteingang t und einen Informationseingang e sowie einen Eingang s für ein Schaltsignal $V_2$. Innerhalb der Matrix M sind die innerhalb der einzelnen Matrixzeilen und Matrixspalten angeordneten Schieberegisterzellen $S_{ik}$ nach Maßgabe ihrer Reihenfolge in der betreffenden Zeile bzw. Spalte derart zusammen geschaltet, daß der Informationseingang e einer gegebenen Registerzelle $S_{ik}$ mit dem korrespondierenden Signalausgang a sowohl der Registerzelle $S_{i-1, k}$ als auch der Registerzelle $S_{i,k-1}$ verbunden ist, während der Signalausgang a der Registerzelle $S_{ik}$ an dem Informationseingang e der Registerzellen $S_{i+1,k}$ und $S_{i,k+1}$ liegt.

Somit bilden die innerhalb einer jeden Zeile i der Matrix M liegenden Registerzellen $S_{ik}$ mit $k = 1, 2, \ldots n$ ein vollständiges Schieberegister mit dem Ausgang $A_i$. Außerdem bilden sämtliche innerhalb der einzelnen Spalte k der Matrix M vorgesehene Registerzellen $S_{ik}$ mit $i = 1, 2, \ldots m$ ebenfalls zusammen ein Schieberegister, so daß die Matrix M insgesamt $(m+n)$ Schieberegister enthält (n = Gesamtzahl der Matrixzeilen, m = Gesamtzahl der Matrixspalten). Auch die den Matrixspalten entsprechenden Schieberegister können über den Ausgang a ihrer letzten Registerzelle ein Informationssignal zur Verfügung stellen, das bei Bedarf ausgewertet werden kann.

Die Informationseingänge $D_k$ (k = 1, 2, ... n) der Matrix M dienen bei der erfindungsgemäßen Schaltung außerdem zur Beaufschlagung eines aus den Zellen $R_k$ (k = 1, 2, ... n) aufgebauten weiteren Schieberegisters SR mit dem Ausgang A, das jedoch nicht zur Beaufschlagung der Matrix M vorgesehen ist, sondern die jeweils an den Eingängen $D_1$, $D_2$, ... $D_n$ jeweils anliegende Information, also das jeweils anhängige und aus n Bit bestehende Digitalwort, im Parallelbetrieb aufnimmt und im Serienbetrieb über den Ausgang A an weitere, hier nicht näher zu erörternde Schaltungsteile weitergibt. Zur Steuerung des Schieberegisters SR ist ein Takt $TM_1$ und zu seiner Aktivierung ein Aktivierungssignal $V_1$ vorgesehen.

Für die Taktversorgung der Registerzellen $S_{ik}$ der Speichermatrix M ist ein Taktsignal $TM_2$ vorgesehen, das gleichzeitig an den Takteingängen t aller Registerzellen $S_{ik}$ der Matrix M anhängig ist, wie dies aus Fig. 1 zu erkennen ist. Schließlich ist noch ein weiterer Takt $TM_3$ vorgesehen, der in noch zu beschreibender Weise an die Zellen $S_{ik}$ der Matrix gelegt ist.

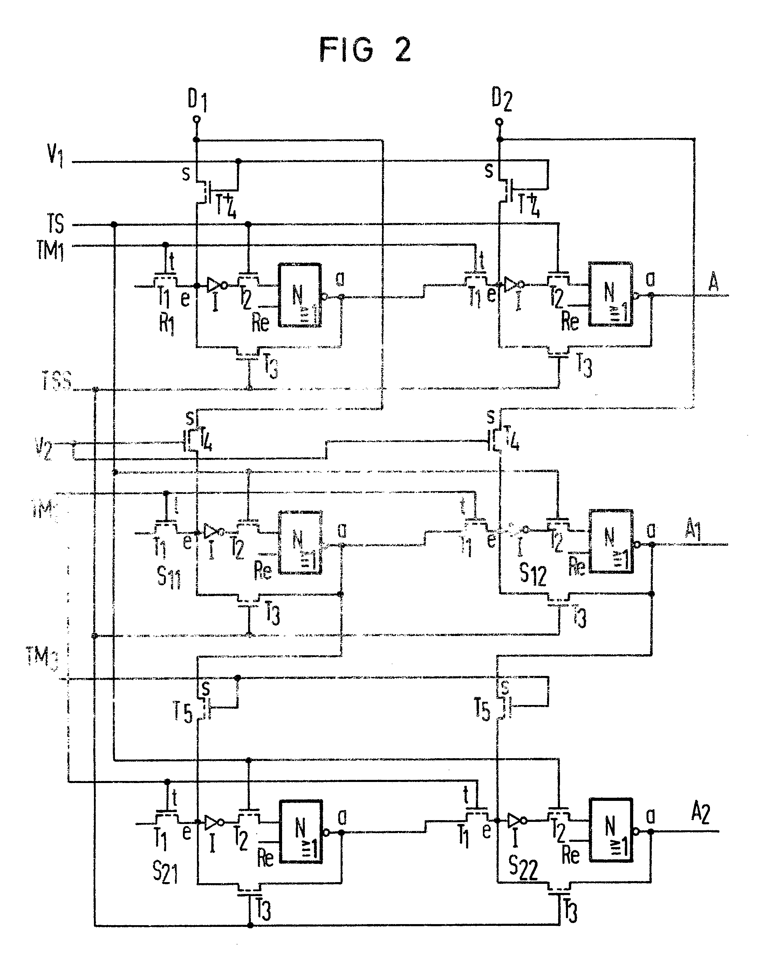

Die praktische Ausführung der in Fig. 1 im Blockschaltbild dargestellten Schaltung gestaltet sich, wie bereits erwähnt, am einfachsten und hinsichtlich der Integrierbarkeit am günstigsten, wenn als Speicherzellen $S_{ik}$ sog. quasistatische Schieberegisterzellen verwendet werden. Dies ist bei dem aus Fig. 2 ersichtlichen Ausführungsbeispiel der Fall.

Die quasistatischen Schieberegisterzellen $S_{ik}$ bestehen in an sich bekannter Weise aus jeweils drei MOS-Feldeffekttransistoren vom Anreicherungstyp, die als Transfertransistoren dienen. Dabei ist der Signaleingang e der einzelnen Zelle $S_{ik}$ über die Source-Drainstrecke eines ersten Transistors $T_1$ mit dem Eingang eines Inverters I und außerdem mit der Source-Drainstrecke des Transfertransistors $T_3$ verbunden. Der Ausgang des Inverters I liegt über der Source-Drainstrecke des Transfertransistors $T_2$ am einen Eingang eines NOR-Gatters N, dessen anderer Eingang durch ein Resetsignal Re zu steuern ist. Über die Reihenschaltung der beiden Transfertransistoren $T_1$ und $T_3$ ist der Signaleingang e der quasistatischen Schieberegisterzelle $S_{ik}$ mit dem durch den Ausgang des NOR-Gatters N gebildeten Ausgang a der quasistatischen Schieberegisterzelle verbunden.

Für die Steuerung der Gates der Transfertransistoren $T_2$ aller dieser quasistatischen Schieberegisterzellen $R_k$ und $S_{ik}$ ist ein gemeinsames Taktsignal TS, zur Steuerung der Gates der Transfertransistoren $T_3$ ein gemeinsames Taktsignal TSS vorgesehen. Die Gates der Eingangs-Transfertransistoren $T_1$ werden, sofern die betreffende Zelle dem Zusatz-Schieberegister SR angehört und es sich somit um eine Zelle $R_k$ handelt, durch den Takt $TM_1$, sofern die betreffende Zelle der eigentlichen Matrix M angehört, also bei den Zellen $S_{ik}$, durch den Takt $TM_2$ gesteuert. Beide Taktfolgen $TM_1$ und $TM_2$ werden zusammen mit dem bereits genannten Takt $TM_3$ von einem Taktsignal TM abgeleitet, welches zusammen mit den Taktfolgen TS und TSS von einem gemeinsamen Taktgeber erzeugt wird. Der Taktgeber ist zweckmäßig entsprechend den Ausführungen der DE-Patentanmeldung P 28 45 379.4 (VPA 78 P 1191) ausgestaltet.

Der in dieser Anmeldung beschriebene Taktgeber ist imstande, drei periodische Taktimpulsfolgen TM, TS und TSS abzugeben, die dieselbe Frequenz aufweisen. Die Taktfolge TM besteht aus zeitlich äquidistanten Rechteckimpulsen mit den Pegeln »0« und »1«. Dasselbe gilt für die Taktfolge TS. Jedoch sind die Impulse der Folge TM so gegen die Impulse der Folge TS abgestimmt, daß die Impulse TS nur dann den Pegel »1« haben, wenn kein Impuls der Folge TM den Pegel »1« hat. Außerdem ist zwischen den Flanken der Einzelimpulse von TM und den Flanken der jeweils benachbarten Einzelimpulse der Folge TS eine nicht verschwindende Zeitdifferenz gegeben, so daß eine Überlappung von Impulsen der Folge TM durch Impulse der Folge TS bzw. eine Überlappung von Impulsen TS durch Impulse TM grundsätzlich ausgeschlossen ist. Die Einzelimpulse der Folge TSS fallen zeitlich mit den Einzelimpulsen der Folge TS zusammen, was exakt für die Übergänge von »1« auf »0« gilt. Hingegen haben die Einzelimpulse der Folge TSS im Gegensatz zu den Impulsen TS merklich schräg ansteigende Übergänge von »0« auf »1« und dementsprechend eine im Vergleich zu den Impulsen TS merklich verkürzte Dauer des Pegels »1« bei den einzelnen Impulsen.

Die Dateneingänge $D_k$ dienen, wie bereits oben erwähnt, jeweils zur Beaufschlagung des Dateneingangs e je einer der Registerzellen $S_{1k}$ der ersten Zeile der Matrix M. Dazu ist jeder der Zellen $S_{1k}$ jeweils ein durch das Aktivierungssignal $V_2$ gesteuerter weiterer Transfertransistor $T_4$ zugeteilt, über welchen der Dateneingang $D_k$ unter Umgehung des vom Takt $TM_2$ gesteuerten Transfertransistors $T_1$ an den Eingang des Inverters I der jeweils zugehörigen Schieberegisterzelle $S_{1k}$ gelegt ist. Das Aktivierungssignal $V_2$ wird — ebenso wie die Takte $TM_1$, $TM_2$ und $TM_3$ und das Aktivierungssignal $V_1$ — aus den Takten der Folge TM abgeleitet.

Die Verbindung zwischen dem Informationsausgang a der Zelle $S_{1k}$ und dem Informationseingang e der jeweils folgenden Zelle $S_{1,k+1}$ der ersten Zeile der Matrix M ist jeweils eine leitende Verbindung gegeben, die im Inneren der folgenden Zelle $S_{1,k+1}$ weiter über den vom Takt $TM_2$ gesteuerten Transfertransistor $T_1$ bis zum Eingang des NOR-Gatters N der betreffenden Zelle verlängert ist. Die Transfertransistoren $T_1$ und $T_4$ dienen also beide der Steuerung der Informationszufuhr an den durch den Eingang des Inverters I gegebenen eigentlichen Eingang e der quasistatischen Schieberegisterzelle $S_{1k}$. Man erkennt unmittelbar, daß beim Auftreten eines Taktes aus der Folge $TM_2$ die Gesamtheit der Registerzellen $S_{1k}$ der ersten Matrixzeile als zum Ausgang $A_1$ führendes Schieberegister arbeitet, während beim Auftreten eines Taktes $V_2$ die an den Dateneingängen $D_k$ anliegende Information parallel in dieses Schieberegister und damit in die Matrix M eingelesen wird, während beim Auftreten eines Taktimpulses $TM_2$ die in den Zellen $S_{1k}$ der ersten Matrixzeile eingelesene Information innerhalb des durch diese Zellen gegebenen Schieberegisters jeweils um eine Zelle in Richtung auf den Ausgang $A_1$ verschoben wird.

Ähnlich ist die Schaltung der Schieberegisterzellen $S_{ik}$ in den übrigen Zeilen der Matrix M, also den Zeilen 2 bis m. Demgemäß ist der durch den Inverter I der jeweils betrachteteten Zeile befindlichen Registerzelle $S_{ik}$ gegebene Eingang e der betreffenden Zelle einmal über den durch den Takt $TM_2$ gesteuerten und den Takteingang t bildenden Transfertransistor an den Ausgang a der in derselben Zeile liegenden vorangehenden Zelle $S_{i,k-1}$ gelegt. Außerdem weisen auch diese Registerzellen $S_{ik}$ mit $i \neq 1$ einen zusätzlichen Transfertransistor $T_5$ auf, der durch den bereits genannten Takt $TM_3$ gesteuert ist, und der den durch den Eingang des Inverters I der betreffenden Registerzelle $S_{ik}$ gegebenen Informationseingang dieser Zelle mit dem Signalausgang a der Zelle $S_{i-1,k}$, also der in der betreffenden Matrixspalte jeweils vorgestellten Registerzelle verbindet.

Man erkennt unmittelbar, daß durch die Aktivierung der Transfertransistoren $T_1$ durch das Signal $TM_2$ die Registerzellen innerhalb der einzelnen Zeilen sich zu einem Schieberegister ergänzen, während durch Aktivierung der Transfertransistoren $T_5$ durch das Signal $TM_3$ die innerhalb der einzelnen Spalten liegenden Registerzellen ihrerseits ein Schieberegister zusammen bilden.

Die Ausgänge der Matrix M sind durch die Signalausgänge a der Registerzellen $S_{in}$ der letzten Matrixspalte gegeben. Als weitere Ausgänge können ggf. auch die Signalausgänge a der Registerzellen $S_{mk}$ der letzten Matrixzeile dienen.

Die Dateneingänge $D_k$ der Matrix M sind in zu den Registerzellen $S_{1k}$ der ersten Matrixzeile analoger Weise an den Dateneingang a je einer Registerzelle $R_k$ des Zusatzschieberegisters SR gelegt und ermöglichen auf diese Weise die Paralleleinschreibung der an den Eingängen $D_k$ anhängigen Information in dieses Schieberegister SR. Hierzu ist der jeweilige Dateneingang $D_k$ an den Eingang e der jeweils zugeordneten Registerzelle $R_k$ über die Source-Drainstrecke je eines Transfertransistors $T_4^+$ gelegt, während die Verbindung zwischen dem Ausgang der Zelle $R_k$ und der jeweils folgenden Zelle $R_{k+1}$ über den Transfertransistor $T_1$ der betreffenden Registerzelle $R_{k+1}$ vermittelt wird. Die Gesamtheit der Transfertransistoren $T_4^+$ wird durch das Signal $V_1$ gesteuert, das ebenso wie das Signal $V_2$ von den Takten TM abgeleitet wird. Die Gesamtheit

der Transfertransistoren $T_1$ der Zellen $R_k$ des Zusatzschieberegisters SR wird hingegen von den bereits erwähnten Takten $TM_1$ gesteuert, die ebenfalls mittels der Takte TM gewonnen werden.

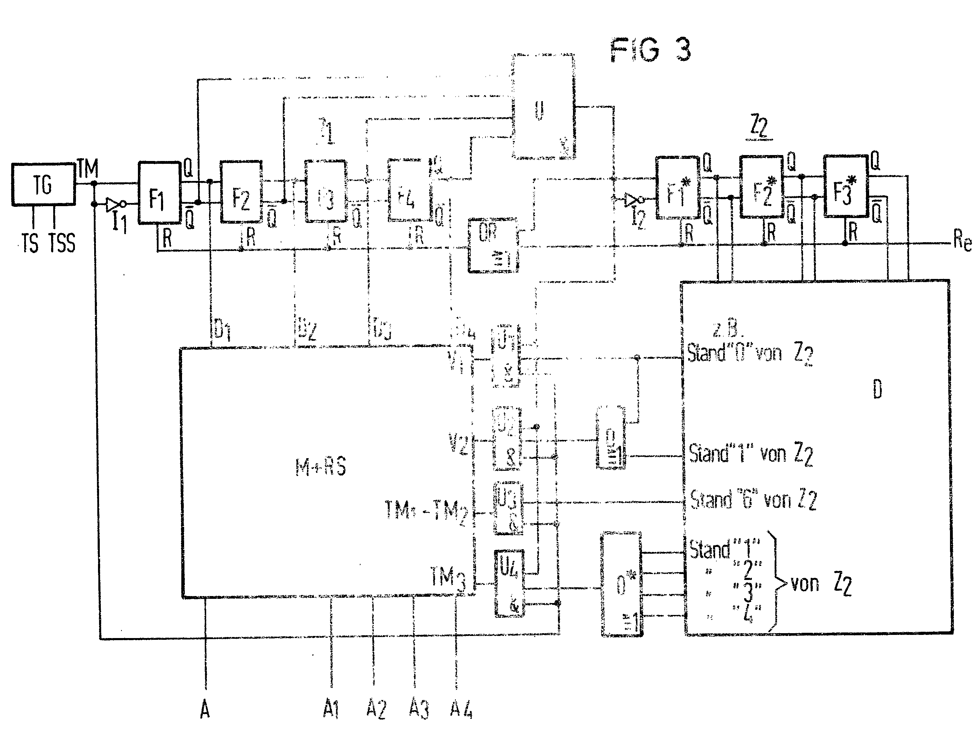

Hinsichtlich der Erzeugung der zum Betrieb der Schaltung gemäß Fig. 1 und Fig. 2 benötigten Signale $TM_1$, $TM_2$, $TM_3$, $V_1$ und $V_2$ wird auf die Fig. 3 verwiesen.

Bei der in Fig. 3 dargestellten Schaltung ist die Speichermatrix M und das Schieberegister SR durch einen gemeinsamen Block M+RS angedeutet. Ein gemeinsamer Taktgeber TG ist vorgesehen. Er ist zur Abgabe der Impulsfolgen TS, TSS und einer Impulsfolge TM geeignet. Die Impulse erscheinen mit gleicher Frequenz. Der die Impulsfolge TS liefernde Ausgang des Taktgebers TG liegt an den Gates der Transfertransistoren $T_2$ aller Schieberegisterzellen $S_{ik}$ und $R_k$. Der die Impulse TSS liefernde Ausgang des Taktgebers TG ist mit den Gates der Transistoren $T_3$ der genannten Schieberegisterzellen verbunden. Der die Impulse TM liefernde Ausgang des Taktgebers TG schließlich ist an den einen Eingang und über einen Inverter $I_1$ an den anderen Eingang eines aus vier Zählstufen aufgebauten Dualzählers $Z_1$ gelegt. Die Anzahl der Zählstufen $F_k$ des Dualzählers $Z_1$ entspricht im allgemeinen Fall der Anzahl der Dateneingänge $D_k$ und damit der Anzahl n der Spalten der Speichermatrix M. Dementsprechend sind die einzelnen Zählstufen $F_k$ des Dualzählers $Z_1$ jeweils einem Dateneingang $D_k$ und den von diesem beaufschlagten Registerzellen $S_{1k}$ bzw. $R_k$ zugeordnet. Die Zählstufen $F_k$ sind im Beispielsfall durch je ein Toggle-Flip-Flop gegeben. Dementsprechend führen die Q-Ausgänge der Zählstufen $F_k$ in der Reihenfolge ihrer Anordnung im Dualzähler $Z_1$ den Zählstand und die $\overline{Q}$-Ausgänge den invertierten Zählstand. Demzufolge ist der $\overline{Q}$-Ausgang der Zählstufe $F_k$ mit dem Dateneingang $D_k$ der Matrix M verbunden.

Ein vorgegebener Zählstand des Dualzählers $Z_1$ dient zur Steuerung eines UND-Gatters U. In dem in Fig. 3 dargestellten Ausführungsbeispiel ist dies der Zählstand »12«. Bei diesem Zählstand liegt an den Q-Ausgängen der Zählstufe $F_4$ und der Zählstufe $F_3$ eine »0« und an den Q-Ausgängen der Zählstufen $F_1$ und $F_2$ eine »1«. Demgemäß muß man, um das mit vier Eingängen versehene UND-Gatter U ausschließlich durch den Zählstand »12« zu steuern, die $\overline{Q}$-Ausgänge der Zählstufen $F_1$ und $F_2$ und die Q-Ausgänge der Zählstufen $F_3$ und $F_4$ an je einen Eingang des UND-Gatters U legen, wie dies aus Fig. 3 ersichtlich ist. Ist der Zählstand »12« erreicht, dann erscheint am Ausgang des UND-Gatters U ein Impuls, der folgende Aufgaben hat:

1. Die von dem UND-Gatter U gelieferten Impulse dienen als Zählimpulse für einen zweiten Dualzähler $Z_2$, der gewissermaßen eine Erweiterung des ersten Dualzählers $Z_1$ bildet. Denn jedesmal beim Erscheinen des Zählstandes »12« erhält der Zähleingang des zweiten Dual-

zählers $Z_2$ einen Impuls, mit dessen Hilfe der Zählstand des zweiten Zählstandes aufgebaut wird.

2. Die vom UND-Gatter U gelieferten Impulse dienen außerdem zur Steuerung eines ODER-Gatters OR, dessen anderer Eingang durch Resetimpulse Re zu steuern ist. Der Ausgang dieses ODER-Gatters OR liegt an den Reseteingängen R des ersten Dualzählers $Z_1$, während die Reseteingänge R des zweiten Dualzählers $Z_2$ unmittelbar von den Resetimpulsen beaufschlagt sind. Demzufolge schaltet der erste Dualzähler $Z_1$ jedesmal auf den Zählstand »0«, wenn das UND-Gatter U anspricht (also im Beispielsfall mit dem Erreichen des Zählstandes »12«). Außerdem schalten gleichzeitig die beiden Zähler auf den Zählstand »0«, wenn ein, z. B. über den Taktgeber TG oder einen sonstigen Teil der Schaltung in bekannter Weise zu erzeugender Resetimpuls Re anhängig ist.

Während die Anzahl der Zählstufen des Zählers $Z_1$ gleich der Zahl n der Spalten k der Matrix M ist und die Zahl der verschiedenen Zählstände des Zählers $Z_1$ demgemäß durch $s^{n+1}-1$ gegeben ist, richtet sich die Anzahl der Zählstufen $F_j^*$ (j = 1, 2, 3, ...) des zweiten Dualzählers $Z_2$ nach den Gesichtspunkten, denen die Schaltung im Einzelfall zu dienen hat. Die Aufgabe des Dualzählers $Z_2$ ist, mittels eines Dekoders D die Erzeugung der Takte $TM_1$, $TM_2$, $TM_3$ sowie der Aktivierungssignale $V_1$ und $V_2$ zu steuern. Dabei ist dafür zu sorgen, daß die Impulse $TM_2$ und $TM_3$ nicht gleichzeitig erscheinen, während dies bei den Impulsen $TM_1$ und $TM_2$ in vielen Fällen erwünscht sein kann. Ein Zahlenbeispiel für die Zählstände, bei denen die Impulse $V_1$, $V_2$ usw. erscheinen, ist in Fig. 3 angegeben.

Hinsichtlich des Aufbaus des zweiten Dualzählers $Z_2$ sowie seiner Zählstufen $F_j^*$ gilt dasselbe wie für den Zähler $Z_1$.

Im Beispielsfall besteht der Zähler $Z_2$ aus den Zählstufen $F_1^*$, $F_2^*$, $F_3^*$, wobei der eine Eingang der ersten Zählstufe $F_1^*$ unmittelbar, der zweite Eingang dieser Zählstufe über einen Inverter $I_2$ an den Ausgang des UND-Gatters U gelegt ist. Durch die verschiedenen Ausgänge Q und $\overline{Q}$ ist der Dekoder D gesteuert. Da sich der innere Aufbau des Dekoders D nach allgemein bekannten Gesichtspunkten richtet und von Fall zu Fall verschieden sein kann, ist von detaillierter Darstellung Abstand genommen.

Die zwischen dem Dekoder D und den Eingängen für die Steuerimpulse $TM_1$, $TM_2$, $TM_3$, $V_1$ und $V_2$ der Matrix M vermittelnde Logik kann als ein Teil des Dekoders D aufgefaßt werden. Es besteht aus der ODER-Gattern 0 und 0*, sowie den UND-Gattern $U_1$, $U_2$, $U_3$, $U_4$, die in der aus Fig. 3 ersichtlichen Weise durch den Taktgeber TG mit dem Takt TM, durch den Ausgang des UND-Gatters U sowie durch einzelne Zählstände des Dualzählers $Z_2$ über den Dekoder D gesteuert sein können. Auch hier soll von der Beschreibung von Einzelheiten abgesehen werden, sofern sie nicht aus der Fig. 3 zu ersehen sind.

Wie aus Fig. 3 hervorgeht, dienen die von dem UND-Gatter U gelieferten Impulse nicht nur zur Steuerung des Zählers $Z_2$ und — über das ODER-Gatter OR zur Steuerung der Rücksetzung des Dualzählers $Z_1$, sondern auch noch dazu, um die Impulse $TM_1$, $TM_2$, $TM_3$, $V_1$ und $V_2$ abzuleiten. Das UND-Gatter $U_1$ dient zur Erzeugung des Signals $V_1$. Es hat drei Eingänge, wovon der erste durch den Ausgang des UND-Gatters U, der zweite durch den vom Taktgeber TG gelieferten Takt TM und der dritte durch den Dekoder D nach Maßgabe bestimmter Zustände des Zählers $Z_2$ gesteuert ist. Im Beispielsfall ist dies der Zählstand »0«.

Das UND-Gatter $U_2$ dient zur Erzeugung des Signals $V_2$. Es hat ebenfalls drei Eingänge, von denen der erste durch das UND-Gatter U, der zweite durch den Takt TM und der dritte durch den Dekoder D unter Vermittlung des ODER-Gatters 0 bei den Zählständen »0« und »1« des Zählers $Z_2$ gesteuert ist. Das der Erzeugung der Impulsfolgen $TM_1$ und $TM_2$ dienende UND-Gatter $U_3$ hat zwei Eingänge, von denen der eine durch den Dekoder D (z. B. beim Zählstand »6« von $Z_2$) gesteuert ist.

Der Takt $TM_3$ dient der Aufgabe, eine spaltenparallele Informationsverschiebung in der Matrix M zu ermöglichen. Für seine Erzeugung ist das UND-Gatter $U_4$ vorgesehen, dessen erster Eingang durch das UND-Gatter U, dessen zweiter Eingang durch den vom Taktgeber TM und dessen letzter Eingang unter Vermittlung des ODER-Gatters O* über den Dekoder D bei den Zählständen »1«, »2«, »3« und »4« des Dualzählers $Z_2$ gesteuert ist.

Zu bemerken ist, daß es sich bei der beschriebenen Weise der Steuerung der Matrix M über den Dualzähler $Z_2$ sich nur um ein Ausführungsbeispiel handelt, das auf einen bestimmten Zweck (Steuerung einer elektronischen Orgel) gerichtet ist. Demzufolge richtet sich die Anzahl der Zählstufen des zweiten Dualzählers $Z_2$ in diesem Fall nach der Zahl der für die Taktsteuerung erforderlichen Zustände (sowie nach der Zahl der verwendeten Oktaven), um hierfür im einzelnen die verschiedenen Zustände zu gewährleisten.

Die Takte TM, TS und TSS werden vom Taktgeber TG kontinuierlich geliefert. Beim Auftreten eines Aktivierungssignals $V_1$ geht die an den Dateneingängen $D_k$ jeweils anliegende Information im Parallelbetrieb in das Zusatzschieberegister SR und beim Auftreten eines Aktivierungssignals $V_2$ in das durch die Gesamtheit der Speicherzellen $S_{1k}$ der ersten Zeile der Matrix M gegebene Schieberegister. Für die Weitergabe der Information aus der ersten Zeile der Matrix M in die zweite Zeile bzw. die folgenden Zeilen ist ein Takt $TM_3$ erforderlich, während beim Auftreten eines Taktes $TM_2$ die Information innerhalb des durch die jeweilige Matrixzeile definierten Schieberegisters bis zu dessen Ausgang $A_i$ erfolgen kann. Es ist deshalb angebracht, wenn die Taktimpulse $TM_2$ und $TM_3$ nicht gleichzeitig erscheinen.

Beispielsweise ist folgende Betriebsweise möglich: In das erste Schieberegister SR werden die anfallenden Binärworte seriell oder parallel eingegeben, was jedesmal beim Auftreten eines Taktimpulses $V_1$ der Fall ist. Ebenso geht die Information beim Auftreten des Aktivierungsimpulses $V_2$ an das durch die erste Matrixzeile gegebene Schieberegister, was ebenfalls durch paralleles Einlesen über die Dateneingänge $D_k$ als auch durch serielle Eingabe über die erste Registerzelle $S_{11}$ der ersten Zeile unter Vermittlung der Takte $TM_2$ (die dann ohne Unterbrechung durch Takte $TM_3$ erfolgt) möglich ist. Weitere ankommende Datenworte werden jeweils nach Übergang der in der ersten Matrixzeile vorhandenen Information in die zweite Matrixzeile und von da in die dritte Zeile usw. von dem durch die erste Matrixzeile gegebenen Schieberegister parallel oder im Serienbetrieb aufgenommen. Dabei kann z. B. die Informationsaufnahme und Informationsweitergabe im Zusatzschieberegister SR gesperrt sein, wenn die Aktivierungsimpulse $V_1$ nicht gegeben werden. Dadurch bleiben bei dem in Fig. 1 dargestellten Ausführungsbeispiel die vier zuletzt eingegebenen Worte in den durch die Zeilen der Matrix M gegebenen Schieberegistern und das zuerst eingegebene Wort im Zusatzschieberegister SR stehen. Nun können alle diese Schieberegister mit den (gleichzeitig erscheinenden) Impulsen $TM_1$ und $TM_2$ beaufschlagt werden, so daß die jeweils gespeicherten Binärworte an den Ausgängen A, $A_1$, ... $A_m$, also beispielsweise A, $A_1$—$A_4$, erscheinen.

Sollen stattdessen z. B. die drei ersten und die zwei letzten Binärworte ausgesucht und abgespeichert werden, so sind die drei ersten Worte in drei aufeinanderfolgenden Schieberegistern entsprechend dem Schieberegister SR vorzusehen, in die parallel oder seriell die Worte eingeschoben werden können. Das Steuerwerk gibt weitere Schiebeimpulse nur auf die restlichen zwei Schieberegister. In diesem werden dann nur die letzten zwei Worte aufgespeichert. Auch eine Hintereinanderschaltung der einzelnen Schieberegister ist möglich. Die einzelnen Teile erhalten aber nur dann Schiebeimpulse, wenn ein Wort auftritt, das z. B. von der Leerinformation abweicht.

Die zu verarbeitenden Digitalworte können aus verschiedenen Quellen stammen. Eine mögliche Quelle ist durch den ersten Dualzähler $Z_1$ gegeben, dessen Zählausgänge Q und ggf. auch $\bar{Q}$ dann nach Maßgabe der Reihenfolge der Zählstufen $F_k$ und der Reihenfolge der Spalten k der Matrix M je einem der Dateneingänge $D_k$ zugeordnet, d. h. in diesem Falle direkt bzw. indirekt mit dem betreffenden Dateneingang $D_k$ verbunden sind.

Es steht außerdem die Möglichkeit offen, jedem der zeilenparallelen Schieberegister bzw. jedem der spaltenparallelen Schieberegister der Matrix M individuell bei entsprechender Abänderung der Takterzeugung und Taktzufuhr jeweils einen individuellen Schiebetakt zuzuordnen.

## Patentansprüche

1. Integrierte Schaltung mit einer Matrix aus einander gleichen Schieberegisterzellen, bei der einerseits die zu den einzelnen Matrixzeilen gehörenden Schieberegisterzellen zu je einem zeilenparallel arbeitenden Schieberegister und andererseits die zu den einzelnen Matrixspalten gehörenden Schieberegisterzellen zu je einem spaltenparallel arbeitenden Schieberegister zusammenfaßbar sind und der jeweilige dieser beiden Betriebszustände durch je ein Signal ausgelöst wird, dadurch gekennzeichnet, daß den einzelnen Schieberegisterzellen ($S_{1k}$) der ersten Zeile der Matrix (M) je eine weitere Schieberegisterzelle ($R_k$) zugeordnet ist, indem je ein zu einem solchen Paar von Schieberegisterzellen ($S_{1k}$, $R_k$) gehörender digitaler Dateneingang ($D_k$) einerseits durch ein auf alle diese weiteren Schieberegisterzellen ($R_k$) wirkendes erstes Schaltsignal ($V_1$) an den Informationseingang (e) der zum jeweiligen Paar gehörenden weiteren Schieberegisterzelle ($R_k$) und andererseits durch ein auf alle Schieberegisterzellen ($S_{1k}$) der ersten Zeile der Matrix (M) gemeinsam wirkendes zweites Schaltsignal ($V_2$) an den Informationseingang (e) der zum jeweiligen Paar gehörigen Schieberegisterzelle der ersten Matrixzeile anschaltbar ist, daß außerdem die Gesamtheit dieser weiteren Schieberegisterzellen ($R_k$) zu einem weiteren Schieberegister (SR) mit einem Signalausgang (A) zusammengefaßt und zur Informationsverschiebung innerhalb dieses weiteren Schieberegisters (SR) eine erste Taktfolge ($TM_1$) verwendet ist, daß weiterhin für die Informationsverschiebung innerhalb der durch die Schieberegisterzellen ($S_{ik}$) in den einzelnen Zeilen der Matrix (M) gebildeten Schieberegister eine für alle diese Schieberegister gemeinsame zweite Taktfolge ($TM_2$) und für die Informationsverschiebung innerhalb der durch die Schieberegisterzellen ($S_{ik}$) in den einzelnen Spalten der Matrix (M) gebildeten Zählstand Schieberegister eine gemeinsame dritte Taktfolge ($TM_3$) verwendet ist, daß ferner die Ausgänge der zeilenparallel arbeitenden Schieberegister der Matrix (M) je einen weiteren Signalausgang der Schaltung bilden und daß schließlich sowohl die genannten Taktfolgen, als auch die gemeinsamen Umschaltsignale ($V_1$, $V_2$) in einer von einem gemeinsamen Taktgeber (TG) gesteuerten Anlage derart erzeugt sind, daß ein gleichzeitiges Auftreten zweier verschiedener dieser Signale ausgeschlossen ist.

2. Schaltung nach Anspruch 1, dadurch gekennzeichnet, daß jede der vorgesehenen Schieberegisterzellen ($R_k$, $S_{ik}$) aus einem NOR-Gatter (N) einem Inverter (I) und vier Transfertransistoren ($T_1$—$T_4$ bzw. $T_4^+$, $T_5$) besteht, daß dabei der eine Eingang des NOR-Gatters (N) durch ein gemeinsames Rücksetzsignal (RE) beaufschlagt wird und der andere Eingang über einen — durch ein für alle Schieberegisterzellen (S$_{ik}$, R$_k$) gemeinsames erstes Taktsignal (TS) gesteuerten — Transfertransistor (T$_2$) an den Ausgang des Inverters (I) und der Eingang dieses Inverters (I) über einen durch ein zweites für alle Schieberegisterzellen (S$_{ik}$, R$_k$) gemeinsames zweites Taktsignal (TSS) gesteuerten zweiten Transfertransistor (T$_3$) an den den Signalausgang (a) der Schieberegisterzelle (S$_{ik}$, R$_k$) bildenden Ausgang des NOR-Gatters (N) gelegt ist, daß außerdem der Eingang des Inverters (I) den Informationseingang (e) der Schieberegisterzelle bildet und über je einen der beiden anderen Transfertransistoren (T$_1$, T$_4$ bzw. T$_4^+$, T$_5$) mit Information versorgt ist, daß hierzu über den einen (T$_1$) der beiden anderen Transfertransistoren entweder eine Verbindung zum Ausgang (a) einer in der betreffenden Matrixzeile vorgeschalteten Schieberegisterzelle oder zu einem ggf. vorhandenen Signaleingang und über den zweiten (T$_4$, bzw. T$_4^+$, T$_5$) der beiden anderen Transfertransistoren entweder eine Verbindung zum Ausgang (a) der in der betreffenden Matrixspalte der betreffenden Schieberegisterzelle (S$_{(i-1),k}$) oder eine Verbindung zu einem der Dateneingänge (D$_k$) gegeben ist, und daß schließlich die zur Steuerung der am Eingang und am Ausgang der NOR-Gatter (N) liegenden Transfertransistoren (T$_2$, T$_3$) vorgesehenen Impulse der für alle Schieberegisterzellen gemeinsamen Impulsfolgen (TS, TSS) praktisch gleichzeitig auftreten und in die Pausen zwischen den Impulsen der zur Steuerung der am Eingang (e) der in allen Schieberegisterzellen (S$_{ik}$, R$_k$) vorgesehenen Inverter (I) liegenden beiden Transfertransistoren (T$_1$, T$_4$ bzw. T$_4^+$, T$_5$) dienenden Impulsfolgen (TM$_1$, TM$_2$, TM$_3$ bzw. V$_1$ und V$_2$) fallen.

3. Schaltung nach Anspruch 1 oder 2, dadurch gekennzeichnet, daß zur Erzeugung der für die Informationsweitergabe zwischen den vorgesehenen Schieberegisterzellen (S$_{ik}$, R$_k$) vorgesehenen Impulsfolgen (TM$_1$, TM$_2$, TM$_3$, V$_1$, V$_2$) eine von einem Taktgeber (TG) gelieferte Folge (TM) periodischer Impulse zur Beaufschlagung eines Dualzählers (Z$_2$) und wenigstens je ein Zählstand dieses Zählers (Z$_2$) zur Erzeugung der gewünschten diskreten Impulsfolgen (TM$_1$, TM$_2$, TM$_3$, V$_1$, V$_2$) unter Verwendung eines gemeinsamen Dekoders und/oder einer entsprechenden Logik verwendet ist.

## Claims

1. An integrated circuit comprising a matrix which consists of mutually identical shift register cells, wherein the shift register cells which constitute the individual matrix rows can be combined to form a shift register which operates in row parallel fashion, and the shift register cells which constitute the individual matrix columns can be combined to form a shift register which operates in column parallel fashion, and each of these two operating states is triggered by a specific signal, characterised in that the individual shift register cells (S$_{1k}$) of the first row of the matrix (M) are each assigned a further shift register cell (R$_k$), in that a digital data input (D$_k$) assigned to each such pair of shift register cells (S$_{1k}$, R$_k$) can be connected by a first switching signal (V$_1$) which acts upon all these further shift register cells (R$_k$) to the information input (e) of the further shift register cell (R$_k$) assigned to the pair in question, and can be connected by a second switching signal (V$_2$) which commonly acts upon all the shift register cells (S$_{1k}$) of the first row of the matrix (M) to the information input (e) of the shift register cell of the first matrix row which is assigned to the pair in question, that moreover these further shift register cells (R$_k$) in their entirety are assembled to form a further shift register (SR) having a signal output (A), and a first clock pulse sequence (TM$_1$) is used for information relocation within this further shift register (SR), that moreover a second clock pulse sequence (TM$_2$) common to all these shift registers is used for information relocation within the shift registers formed by the shift register cells (S$_{ik}$) in the individual rows of the matrix (M), and a common third clock pulse sequence (TM$_3$) is used for information relocation within the shift registers formed by the shift register cells (S$_{ik}$) in the individual columns of the matrix (M), that moreover the outputs of the shift registers within the matrix (M) which operate in row parallel fashion each form a further signal output of the circuit, and that finally both the aforementioned clock pulse sequences and also the common switch-over signals (V$_1$, V$_2$) are produced in a unit controlled by a common clock pulse generator (TG) in such manner that simultaneous occurrence of two different members of these signals is eliminated.

2. A circuit as claimed in Claim 1, characterised in that each of the existing shift register cells (R$_k$, S$_{ik}$) consists of a NOR gate (N), an inverter (I) and four transfer transistors (R$_1$—T$_4$ and T$_4^+$, T$_5$), that the first input of the NOR gate (N) is supplied with a common reset signal (RE) and the other input is connected via a transfer transistor (T$_2$), controlled by a first clock pulse signal (TS) common to all the shift register cells (S$_{ik}$, R$_k$), to the output of the inverter (I), whereas the input of this inverter (I) is connected via a second transfer transistor (T$_3$), controlled by a second clock pulse signal (TSS) common to all the shift register cells (S$_{ik}$, R$_k$), to that output of the NOR gate (N) which forms the signal output (a) of the shift register cell (S$_{ik}$, R$_k$), that moreover the input of the inverter (I) forms the information input (e) of the shift register cell and is supplied with information via one of the two other transfer transistors (T$_1$, T$_4$ and T$_4^+$, T$_5$), that for this purpose via one (T$_1$) of the two other transfer transistors a connection is established either to the output (a) of a preceding shift register cell in the relevant matrix row or to any signal input which may be present, whereas via the second

(T$_4$ and T$_4$+, T$_5$) of the two other transfer transistors a connection is established either to the output (a) of the relevent register cell (S$_{i-1,k}$) in the matrix column in question or to one of the data inputs (D$_k$), and that finally the pulse of the pulse sequences (TS, TSS) which are common to all the shift register cells and are provided to control the transfer transistors (T$_2$, T$_3$) located at the input and output of the NOR gates (N) occur virtually simultaneously, and fall in the intervals between the pulse sequences (TM$_1$, TM$_2$, TM$_3$ and V$_1$ and V$_2$) which serve to control the two transfer transistors (T$_1$, T$_4$ and T$_4$+, T$_5$) which are located at the input (e) of the inverters (I) provided in all the shift register cells (S$_{ik}$, R$_k$).

3. A circuit as claimed in Claim 1 or 2, characterised in that for the generation of the pulse sequences (TM$_1$, TM$_2$, TM$_3$, V$_1$, V$_2$) which serve to convey information between the shift register cells (S$_{ik}$, R$_k$) a sequence (TM) of periodic pulses supplied by a clock pulse generator (TG) is used to feed a dual counter (Z$_2$), and at least one count of this counter (Z$_2$) is used to produce the desired discrete pulse sequences (TM$_1$, TM$_2$, TM$_3$, V$_1$, V$_2$) employing a common decoder and/or a corresponding logic unit.

## Revendications

1. Circuit intégré avec une matrice constistuée par des cellules, identiques entre elles d'une mémoire à décalage, dans lequel, d'une part, les cellules du registre à décalage appartenant aux différentes lignes de la matrice sont rassemblées en un registre à décalage opérant par lignes parallèles, et, d'autre part, des cellules du registre à décalage appartenant aux différentes colonnes de la matrice sont rassemblées en un registre à décalage opérant par colonnes parallèles, celui des deux états de fonctionnement qui est concerné étant déclenché par un signal, caractérisé par le fait qu'aux diverses cellules (S$_{1k}$) du registre à décalage de la ligne de la matrice (M) est respectivement associée une cellule de registre à décalage supplémentaire (R$_k$) en faisant en sorte qu'une entrée des données numériques (D$_k$) appartenant à une telle paire de cellules de registre à décalage (S$_{1k}$, R$_k$) est susceptible d'être branchée, d'une part, par l'intermédiaire d'un premier signal de commutation (V$_1$) agissant sur toutes ses cellules supplémentaires (R$_k$) du registre à décalage, à l'entrée (e) des informations de la cellule de registre à décalage supplémentaire (R$_k$) appartenant à la paire concernée, et, d'autre part, par l'intermédiaire d'un second signal de commutation (V$_2$) agissant sur toutes les cellules (S$_{1k}$) du registre à décalage de la première ligne de la matrice, à l'entrée d'informations (e) de la cellule de registre à décalage de la première ligne de matrice, appartenant à la paire concernée, qu'en outre la totalité de ces cellules supplémentaires (R$_k$) du registre à décalage sont rassemblées pour former un registre à décalage supplémentaire (SR) possédant une sortie de signaux (A) et que pour le décalage de l'information dans ce registre à décalage supplémentaire (SR), on utilise un train de signaux de cadence (TM$_1$), qu'en outre on utilise pour le décalage des informations dans les registres à décalage formés par les cellules de registre à décalage (S$_{ik}$) dans les différentes lignes de la matrice (M), un second train de signaux de cadence (TM$_2$), qui est commun pour tous ces registres à décalage, et pour le décalage des informations dans les registres à décalage formés par les cellules (S$_{ik}$) du registre à décalage, dans les différentes colonnes de la matrice (M), un troisième train de signaux de cadence (TM$_3$), qu'en outre, les sorties des registres à décalage de la matrice (M) qui opèrent par lignes parallèles, forment chacune une sortie supplémentaire de signaux pour le circuit, et qu'enfin lesdits trains de signaux de cadence, de même que les signaux communs de commutation (V$_1$, V$_2$) sont produits de telle façon dans un générateur commun (TG) de signaux de cadence, qu'une apparition simultanée de deux différents de ces signes est exclue.

2. Circuit selon la revendication 1, caractérisé par le fait que chacune des cellules de registre à décalage (R$_k$, S$_{ik}$) qui sont prévues, est constituée par une porte NON-OU (N) par un inverseur (I) et par quatre transistors de transfert (T$_1$—T$_4$ et T$_4$+, T$_5$), que l'une des entrées de la porte NON-OU (N) est chargée par un signal commun de remise à l'état initial (RE) et l'autre entrée est reliée par un transistor de transfert (T$_2$) commandé par un signal de cadence (TS) commun pour toutes les cellules de registre à décalage (S$_{ik}$, R$_k$), à la sortie de l'inverseur (I) et l'entrée de cet inverseur (I) est reliée par l'intermédiaire d'un second transistor de transfert (T$_3$) commandé par un second signal de cadence (TSS) sommun à toutes les cellules du registre à décalage (S$_{ik}$, R$_k$), à la sortie de la porte NON-OU (N) qui forme la sortie (a) des signaux des cellules de registre à décalage (S$_{ik}$, R$_k$), qu'en outre l'entrée de l'inverseur (I) forme l'entrée (e) des informations de la cellule de registre à décalage et est alimentée par l'un des deux autres transistors de transfert (T$_1$, T$_4$ et T$_4$+, T$_5$) en information, qu'à cet effet, par l'intermédiaire de l'un (T$_1$) des deux autres transistors de transfert est établie soit une liaison avec la sortie (a) d'une cellule de registre à décalage située en amont de la ligne concernée de la matrice ou avec une entrée de signaux qui existe éventuellement, ou, par l'intermédiaire du second (T$_4$ ou T$_4$+, T$_5$) des deux autres transistors de transfert, soit une liaison avec la sortie (a) de la colonne concernée de la matrice de la cellule concernée (S$_{(i-l),k}$) du registre à décalage, ou une liaison avec une des entrées de données (D$_k$) et qu'enfin les impulsions des trains d'impulsions (TS, TSS), communs pour toutes les cellules de registre à décalage, et qui sont prévues pour la commande des transistors de transfert (T$_2$, T$_3$) reliés à

l'entrée et à la sortie des portes NON-OU (N), apparaissent pratiquement en même temps et se situent dans les intervalles entre les impulsions des trains d'impulsions ($TM_1$, $TM_2$, $TM_3$ ou $V_1$ et $V_2$) qui servent à la commande des deux transistors de transfert ($T_1$, $T_4$ et $T_4^+$, $T_5$) qui se situent à l'entrée (e) des inverseurs (I) prévus dans toutes les cellules ($S_{ik}$, $R_k$) des registres à décalage.

3. Circuit selon la revendication 1 ou 2, caractérisé par le fait que pour produire les trains d'impulsions ($TM_1$, $TM_2$, $TM_3$, $V_1$, $V_2$) prévus pour la transmission des informations entre les cellules ($S_{ik}$, $R_k$) prévues des registres à décalage, on utilise un train (TM) période d'impulsions fournies par un générateur de signaux de cadence (TG) pour alimenter un compteur bidirectionnel ($Z_2$) et au moins un état de comptage de ce compteur ($Z_2$) pour produire les trains d'impulsions discrets ($TM_1$, $TM_2$, $TM_3$, $V_1$, $V_2$) avec mise en oeuvre d'un décodeur commun et/ou d'une logique correspondante.

# FIG 1

0 021 084

# FIG 2

FIG 3